(19)

Europäisches Patentamt

European Patent Office

Office européen des brevets

(11) **EP 4 521 568 A1**

(12) **EUROPEAN PATENT APPLICATION**
published in accordance with Art. 153(4) EPC

(43) Date of publication:
**12.03.2025 Bulletin 2025/11**

(21) Application number: **23823728.3**

(22) Date of filing: **02.06.2023**

(51) International Patent Classification (IPC):
$H01S\ 5/11^{(2021.01)}$   $H01S\ 5/183^{(2006.01)}$

(52) Cooperative Patent Classification (CPC):
**H01S 5/11; H01S 5/183; H01S 5/185**

(86) International application number:
**PCT/JP2023/020608**

(87) International publication number:
**WO 2023/243435 (21.12.2023 Gazette 2023/51)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **14.06.2022 JP 2022095656**

(71) Applicants:
• **Kyoto University
Kyoto-shi, Kyoto 606-8501 (JP)**
• **Stanley Electric Co. Ltd.
Tokyo 153-8636 (JP)**

(72) Inventors:
• **NODA, Susumu
Kyoto-shi, Kyoto 606-8501 (JP)**
• **INOUE, Takuya
Kyoto-shi, Kyoto 606-8501 (JP)**
• **KOIZUMI, Tomoaki
Tokyo 153-8636 (JP)**
• **EMOTO, Kei
Tokyo 153-8636 (JP)**

(74) Representative: **Klang, Alexander H.
Wagner & Geyer Partnerschaft mbB
Patent- und Rechtsanwälte
Gewürzmühlstrasse 5
80538 München (DE)**

(54) **SURFACE-EMITTING LASER ELEMENT**

(57)    A first semiconductor layer provided on a light-transmitting substrate, an active layer on the first semiconductor layer, a second semiconductor layer on the active layer, a photonic crystal layer that is included in the first semiconductor layer and includes air holes disposed with a two-dimensional periodicity in a plane parallel to the active layer, and a light reflection layer that is provided on the second semiconductor layer and has a reflecting surface, are included. A light emission surface is provided on a back surface of the substrate, the photonic crystal layer has a diffraction surface that is a wave source when standing light is diffracted in a direction orthogonal to the photonic crystal layer, and a separation distance between the diffraction surface and the reflecting surface is provided such that a light intensity of interference light generated by interference between first diffracted light diffracted from the diffraction surface to a side of the light emission surface and second diffracted light diffracted from the diffraction surface to a side of the light reflection layer and reflected on the reflecting surface is smaller than a light intensity of the first diffracted light.

FIG.1A

EP 4 521 568 A1

## Description

Technical Field

The present invention relates to a surface-emitting laser element, and particularly to a surface-emitting laser element having a photonic crystal.

Background Art

In recent years, the development of a photonic-crystal surface-emitting laser using a photonic crystal (PC) has progressed.

For example, Patent Literature 1 discloses a photonic-crystal surface-emitting laser having a cladding layer in which a composition of Al changes, which strengthens the light confinement of light in a direction parallel to a photonic crystal layer and reduces loss.

Furthermore, Patent Literature 2 discloses a surface-emitting laser in which a photonic crystal layer is formed in a p-type $In_xGa_{1-x}N$ layer, which can reduce light absorption by Mg and aims to reduce an oscillation threshold.

Patent Literature 3 discloses a surface-emitting laser that includes a first photonic crystal layer and a second photonic crystal layer, the optical thicknesses of which are made equal. That is, a surface-emitting laser is disclosed in which light diffracted in a vertical direction to the photonic crystal layer in each photonic crystal is weakened by interference, thereby reducing a light component diffracted in the vertical direction.

Furthermore, Non Patent Literature 1 discloses a formulation of diffracted light of a photonic-crystal surface-emitting laser, a diffracted radiation wave profile that is diffracted in a photonic crystal layer and emitted in a direction perpendicular to the photonic crystal layer, and the like.

Citation List

Patent Literatures

Patent Literature 1: Japanese Patent Application Laid-Open No. 2008-227095
Patent Literature 2: Japanese Patent Application Laid-Open No. 2010-232488
Patent Literature 3: Japanese Patent Application Laid-Open No. 2014-67945

Non-Patent Literature

Non-Patent Literature 1: Y. Liang et al.: Phys. Rev. B vol. 84, 195119 (2011)

Summary of Invention

Technical problem

However, in the related art described in the above-mentioned Patent Literature 1 and 2 and the like, it is not possible to reduce a resonator loss in the vertical direction. Furthermore, in the related art described in Patent Literature 3, it is difficult to precisely control the thickness of the photonic crystal layer, and therefore it is difficult to reduce the intensity of light diffracted in the vertical direction having a desired beam shape (FFP: Far Field Pattern).

Furthermore, in order to realize wearable devices such as smart glasses, there is a demand for small, low-power laser light sources that can be driven with low current. On the other hand, the light output is required to be low from the viewpoint of directly incident on a human eye. Therefore, there is a demand for a small, low-power, and low-output laser light source, particularly for applications such as wearable devices.

An object of the present invention is to provide a surface-emitting laser element capable of reducing an emission loss, reducing an oscillation threshold current, and reducing a drive current.

Solution to Problem

According to a first aspect of the present invention, there is provided a surface-emitting laser element including:

a light-transmitting substrate;

a first semiconductor layer that is provided on the substrate;

an active layer that is provided on the first semiconductor layer;

a second semiconductor layer that is provided on the active layer;

a photonic crystal layer that is included in the first semiconductor layer and includes air holes disposed with a two-dimensional periodicity in a plane parallel to the active layer; and

a light reflection layer that is provided on the second semiconductor layer and has a reflecting surface,

in which a light emission surface is provided on a back surface of the substrate,

the photonic crystal layer has a diffraction surface that is a wave source when light standing in the photonic crystal layer is diffracted in a direction orthogonal to the photonic crystal layer, and

a separation distance between the diffraction surface and the reflecting surface is provided such that a light intensity of interference light generated by interference between first diffracted light diffracted from the diffraction surface to a side of the light emission surface and second diffracted light diffracted from the diffraction surface to a side of the light reflection layer and reflected on the reflecting surface is smaller than a light intensity of the first diffracted light.

Brief Description of Drawings

FIG. 1A is a cross-sectional view schematically illustrating an example of a structure of a PCSEL element 10 according to a first embodiment of the present invention.

FIG. 1B is a partially enlarged cross-sectional view schematically illustrating a photonic crystal layer 14P (air-hole layer) in FIG. 1A and an air hole 14K arranged in the photonic crystal layer 14P.

FIG. 2A is a plan view schematically illustrating an upper surface of the PCSEL element 10.

FIG. 2B is a cross-sectional view schematically illustrating a cross section of the photonic crystal layer 14P in a plane parallel to an n-side guide layer 14.

FIG. 2C is a plan view schematically illustrating a bottom surface of the PCSEL element 10.

FIG. 3A is a plan view schematically illustrating a main opening K1 and a secondary opening K2 of a resist, and holes 14H1 and 14H2 after etching.

FIG. 3B is a view illustrating a scanning electron microscope (SEM) image of a surface after holes 14H1 and 14H2 are formed.

FIG. 4A is a view schematically illustrating a cross section of the formed photonic crystal layer 14P, perpendicular to a crystal layer.

FIG. 4B is a view illustrating an SEM image of a surface after main air holes 14K1 and secondary air holes 14K2 are formed.

FIG. 5 is a table showing an air hole period PC, a separation distance dr from a wave source WS to a reflecting surface SR, and the like of produced elements Ex. 1 to Ex. 9.

FIG. 6 is a table showing a threshold current density, a slope efficiency, and a phase difference $\theta$ between direct diffracted light Ld and reflected diffracted light Lr of the elements illustrated in FIG. 5.

FIG. 7 is a graph plotting a threshold current density Jth (kA/cm$^2$) with respect to a separation distance dr (nm) for Ex. 1 to Ex. 9.

FIG. 8 is a graph showing $\Gamma_{act}$ and $\Gamma_{PC}$ with respect to a thickness of a p-cladding layer 18.

FIG. 9 is a graph showing $\alpha i$ with respect to the thickness of the p-cladding layer 18.

FIG. 10 is a diagram illustrating a threshold current density Jth with respect to the phase difference $\theta$ between the direct diffracted light Ld and the reflected diffracted light Lr, obtained based on the separation distance dr, for Ex. 1 to Ex. 9.

FIG. 11 is a diagram illustrating a change in a loss $\alpha'$ in the vertical direction normalized at a value of R = 0 with respect to a reflectance R when the phase difference $\theta$ = 180°.

FIG. 12 is a diagram illustrating a differential ($d\alpha'/dR$) of the loss $\alpha'$ with respect to the reflectance R.

FIG. 13 is a cross-sectional view schematically illustrating an arrangement cross section of the main air hole 14K1 and the secondary air hole 14K2 in a depth direction of a double lattice structure.

Description of Embodiments

Hereinafter, preferred embodiments of the present invention will be described, but these embodiments may be appropriately modified and combined. In addition, in the following description and the accompanying drawings, substantially the same or equivalent parts will be described with the same reference numerals.

[First Embodiment]

1. Structure of Photonic-Crystal Surface-Emitting Laser

A photonic-crystal surface-emitting laser (hereinafter also referred to as a PCSEL) includes a resonator layer in a direction parallel to a semiconductor light-emitting structure layer (n-side guide layer, a light-emitting layer, and a p-side guide layer) constituting a light-emitting element, and is an element that radiates coherent light in a direction orthogonal to the resonator layer.

That is, in the photonic-crystal surface-emitting laser (PCSEL), light waves propagating in a plane parallel to a photonic crystal layer are diffracted due to a diffraction effect of the photonic crystal to form a two-dimensional resonance mode and are also diffracted in a direction perpendicular to the parallel plane. That is, in the photonic-crystal surface-emitting laser, a light extraction direction is a vertical direction with respect to the resonance direction (in a plane parallel to the photonic crystal layer).

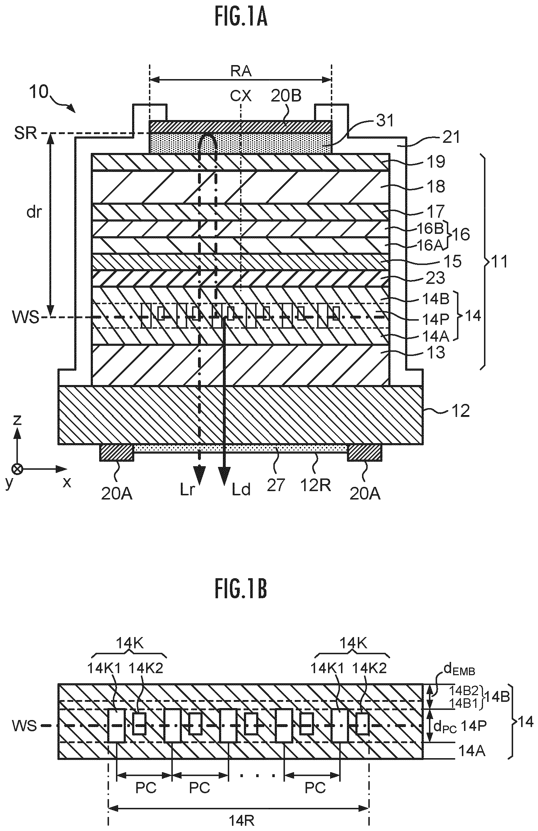

FIG. 1A is a cross-sectional view schematically illustrating an example of a structure of a photonic-crystal surface-emitting laser element (hereinafter referred to as a PCSEL element) 10 according to an embodiment of the present invention. In addition, FIG. 1B is an enlarged cross-sectional view schematically illustrating a photonic crystal layer 14P in FIG. 1A and a pair of air holes 14K arranged in the photonic crystal layer 14P.

As illustrated in FIG. 1A, a semiconductor structure layer 11 is formed on a light-transmitting substrate 12. Semiconductor layers are stacked perpendicularly to a central axis CX of the semiconductor structure layer 11.

In addition, the semiconductor structure layer 11 is made of a hexagonal nitride semiconductor. In the present embodiment, the semiconductor structure layer 11 is made of, for example, a GaN-based semiconductor.

More specifically, the semiconductor structure layer 11 including a plurality of semiconductor layers is formed on the substrate 12, that is, an n-cladding layer (first cladding layer of a first conductivity type) 13, an n-side guide layer (first guide layer) 14 that is a guide layer provided on the n side, a light distribution adjustment layer 23, an active layer (ACT) 15, a p-side guide layer (second guide layer) 16 that is a guide layer provided on the p side, an electron blocking layer (EBL) 17, a p-cladding layer (second cladding layer of a second conductivity type) 18, and a p-contact layer 19 are formed on the substrate 12 in this order.

Although the case where the first conductivity type is an n-type and the second conductivity type that is a conductivity type opposite to the first conductivity type is a p-type will be described, the first conductivity type and the second conductivity type may be a p-type and an n-type, respectively.

The substrate 12 is a hexagonal GaN single crystal and has a high transmittance of light radiated from the active layer 15. More specifically, the substrate 12 is a hexagonal GaN single crystal substrate of which a main surface (crystal growth surface) is a +c-plane hexagonal crystal, which is a {0001} plane in which Ga atoms are arranged on the outermost surface. A back surface (light emission surface) is a -c plane, which is a (000-1) plane in which N atoms are arranged on the outermost surface. The -c plane is resistant to oxidation or the like and is therefore suitable as a light emission surface.

The substrate 12 is not limited thereto, but a so-called just substrate, or, for example, a substrate of which a main surface is offset to about 1° in the m-axis direction is preferably used. For example, the substrate that is offset to about 0.3 to 0.7° in the m-axis direction can obtain mirror-finish growth under a wide range of growth conditions.

A substrate surface (back surface or a light emission surface) on which a light emission region 20L opposite to the main surface is provided is the "-c" plane, which is the (000-1) plane on which N atoms are arranged on the outermost surface. The -c-plane is resistant to oxidation or the like, and is therefore suitable as a light extraction surface.

Hereinafter, configurations such as a composition and a layer thickness of each of the semiconductor layers will be described, but these configurations are merely examples and can be appropriately modified and applied.

The n-cladding layer 13 is, for example, an n-$Al_{0.04}Ga_{0.96}$N layer having an Al composition of 4% and a layer thickness of 2 $\mu$m. The aluminum (Al) composition ratio is based on a composition in which a refractive index is smaller than that of a layer (that is, the n-side guide layer 14) adjacent to the active layer 15 side.

The n-side guide layer 14 includes a lower guide layer 14A, a photonic crystal layer (PC layer) 14P that is an air-hole layer, and an embedded layer 14B. As illustrated in FIG. 1B, the photonic crystal layer 14P has a layer thickness $d_{PC}$ and the embedded layer 14B has a layer thickness $d_{EMB}$. For example, the layer thickness $d_{PC}$ of the photonic crystal layer 14P is 40 to 180 nm.

In the present specification, the photonic crystal layer 14P refers to a layer portion from the upper end to the lower end of the air holes in the n-side guide layer 14 (see FIG. 1B). Therefore, the layer thickness $d_{PC}$ of the photonic crystal layer 14P is equal to the height of the air holes.

The lower guide layer 14A is, for example, n-GaN having a layer thickness of 100 to 400 nm. The photonic crystal layer 14P is n-GaN having a layer thickness (or a depth of the air holes 14K) of 40 to 180 nm.

The embedded layer 14B is made of n-GaN, n-InGaN, or undoped GaN or undoped InGaN. Alternatively, the embedded layer 14B may be a layer in which these semiconductor layers are stacked. The embedded layer 14B has a layer thickness $d_{EMB}$ of, for example, 50 to 150 nm. The embedded layer 14B includes a first embedded layer 14B1 and a second embedded layer 14B2.

The light distribution adjustment layer 23 formed on the embedded layer 14B is an undoped $In_{0.03}Ga_{0.97}N$ layer, and has a layer thickness of, for example, 50 nm.

The n-side guide layer 14 and the light distribution adjustment layer 23 are also referred to as a first semiconductor layer, but the light distribution adjustment layer 23 may not be provided.

The active layer 15 which is a light-emitting layer is, for example, a multiple quantum well (MQW) layer having two quantum well layers. A barrier layer and the quantum well layer of the MQW are a GaN layer (layer thickness: 6.0 nm) and an InGaN layer (layer thickness: 4.0 nm), respectively. In addition, a center emission wavelength of the active layer 15 is 440 nm.

It is preferable that the active layer 15 is disposed within 180 nm (that is, within a period PC of the air holes) from the photonic crystal layer 14P. In this case, a high resonance effect is obtained by the photonic crystal layer 14P.

The p-side guide layer 16 includes a p-side guide layer (1) 16A which is an undoped $In_{0.02}Ga_{0.98}N$ layer (layer thickness 70 nm) and a p-side guide layer (2) 16B which is an undoped GaN layer (layer thickness 180 nm).

The p-side guide layer 16 is an undoped layer in consideration of light absorption by a dopant (Mg: magnesium or the like), but may be doped in order to obtain good electrical conductivity. In addition, in order to adjust an electric field distribution in an oscillation operation mode, the In composition and the layer thickness of the p-side guide layer (1) 16A can be appropriately selected.

The electron blocking layer (EBL) 17 is a p-type $Al_{0.2}Ga_{0.8}N$ layer doped with magnesium (Mg), and has a layer thickness of, for example, 15 nm.

The p-cladding layer 18 is an Mg-doped p-$Al_{0.06}Ga_{0.94}N$ layer, and has, for example, a layer thickness of 600 nm. The Al composition of the p-cladding layer 18 is preferably selected such that a refractive index is smaller than that of the p-side guide layer 16. The p-cladding layer 18 functions as a first p-cladding layer.

In addition, the p-contact layer 19 is an Mg-doped p-GaN layer and has, for example, a layer thickness of 20 nm. A carrier density of the p-contact layer 19 is set to a concentration that allows an ohmic junction to be formed with a light-transmitting electrode 31, which is a light-transmitting conductive layer provided on the surface of the p-contact layer 19. Instead of p-type GaN, p-type or undoped InGaN may be used. Alternatively, a layer in which a GaN layer and an InGaN layer are stacked may be used.

The layer including the p-side guide layer 16, the electron blocking layer 17, the p-cladding layer 18 and the p-contact layer 19 is also referred to as a second semiconductor layer.

In the present specification, an "n-side" and a "p-side" do not necessarily mean having an n-type and a p-type. For example, the n-side guide layer means a guide layer provided on the n-side of the active layer, and may be an undoped layer (or an i layer).

Furthermore, the n-cladding layer 13 may include a plurality of layers rather than a single layer. In that case, all layers do not need to be n layers (n-doped layers), and an undoped layer (i layer) may be included. The same also applies to the p-side guide layer 16 and the p-cladding layer 18.

Furthermore, it is not necessary to provide all of the semiconductor layers described above, and there may be a configuration in which a first semiconductor layer of a first conductivity type including the photonic crystal layer, a second semiconductor layer of a second conductivity type, and an active layer (light-emitting layer) interposed between these layers are provided.

The light-transmitting electrode 31 (anode) that makes ohmic contact with the p-contact layer 19 is provided on the p-contact layer 19. The light-transmitting electrode 31 functions not only as an electrode layer but also as a second p-cladding layer.

The light-transmitting electrode 31 has a circular shape with a diameter RA centered on the central axis CX of the semiconductor structure layer 11. Specifically, the light-transmitting electrode 31 has a diameter RA of, for example, 300 μm when viewed from above.

The light-transmitting electrode 31 is formed of a light-transmitting conductor and is made of, for example, indium tin oxide (ITO). The light-transmitting electrode 31 is not limited to ITO, and a light-transmitting conductor such as zinc tin oxide (ZTO), GZO (ZnO:Ga), or AZO (ZnO:Al) can be used.

On the light-transmitting electrode 31, an Ag/Au layer made of a silver (Ag) layer and a gold (Au) layer formed on the Ag layer is formed as a p-electrode 20B (second electrode). That is, the p-electrode 20B functions as a light reflection layer, and the interface between the light-transmitting electrode 31 and the Ag layer of the p-electrode 20B is a reflecting surface SR. The reflecting surface SR is provided in parallel with the photonic crystal layer 14P.

As the p-electrode 20B, Pd, Al, an Al alloy, a dielectric distributed Bragg reflector (DBR), or the like may also be used. In addition, a pad electrode or the like may be provided on the p-electrode 20B.

The side surface and the upper surface of the semiconductor structure layer 11 and the side surfaces of the light-transmitting electrode 31 and the p-electrode 20B are covered with an insulating film 21 such as $SiO_2$. The insulating film 21 is formed to overlap the p-electrode 20B and cover the edge of the upper surface of the p-electrode 20B.

The insulating film 21 also functions as a protective film and protects the crystal layer containing aluminum (Al) constituting the PCSEL element 10 from a corrosive gas and the like. The insulating film 21 also prevents short circuits or the like due to deposits and creeping-up of a solder during mounting, and contributes to improvement of reliability and yield. A material of the insulating film 21 is not limited to $SiO_2$, and $ZrO_2$, $HfO_2$, $TiO_2$, $Al_2O_3$, SiNx, Si, and the like can be selected.

An annular cathode electrode 20A (first electrode) is formed on the back surface of the substrate 12. In addition, an anti-reflection (AR) coating layer 27 is formed inside the cathode electrode 20A.

The cathode electrode 20A is made of Ti/Au and is in ohmic contact with the substrate 12. In addition to Ti/Au, the electrode material can be selected from Ti/Al, Ti/Rh, Ti/Al/Pt/Au, Ti/Pt/Au, or the like.

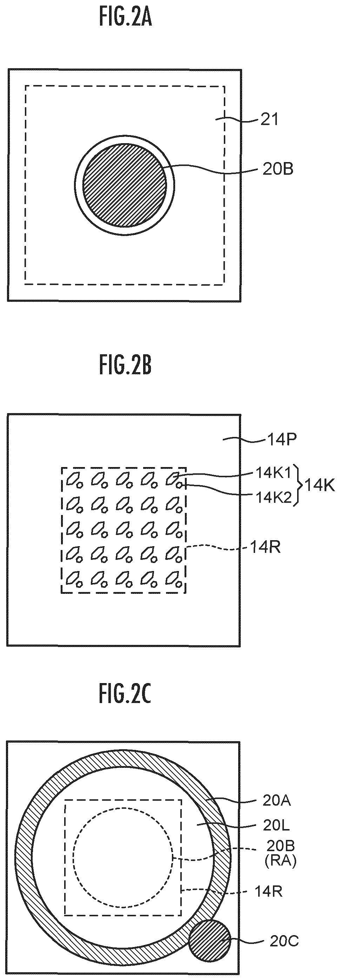

The light radiated from the active layer 15 is diffracted by the photonic crystal layer (PC layer) 14P. Light (direct diffracted light Ld: first diffracted light) diffracted by the photonic crystal layer 14P and directly emitted from the photonic crystal layer 14P, and light (reflected diffracted light Lr: second diffracted light) emitted due to diffraction of the photonic crystal layer 14P and reflected by a light reflection layer 32 are emitted to the outside from the light emission region 20L (FIG. 2C) of a back surface (emission surface) 12R of the substrate 12.

FIG. 2A is a plan view schematically illustrating the upper surface of the PCSEL element 10. FIG. 2A schematically illustrates the upper surface in a state in which a pad electrode 33 is removed for the sake of clarity in the drawing and better understanding.

In addition, FIG. 2B is a cross-sectional view schematically illustrating a cross section of the photonic crystal layer 14P in a plane parallel to the n-side guide layer 14, and FIG. 2C is a plan view schematically illustrating a lower surface of the PCSEL element 10.

As illustrated in FIG. 2B, in the photonic crystal layer 14P, the air holes 14K are provided, for example, by being arranged periodically in a rectangular air hole formation region 14R.

As illustrated in FIG. 2C, an anode region RA is formed to be included in the air hole formation region 14R. The cathode electrode 20A is provided as a ring-shaped electrode outside the p-electrode 20B not to overlap the p-electrode 20B when viewed in a vertical direction with respect to the photonic crystal layer 14P.

The region inside the cathode electrode 20A is a light emission region 20L. Also, a bonding pad 20C that is electrically connected to the cathode electrode 20 and is connected to a wire for supplying power from the outside is provided.

2. Production Method and Structure of Photonic Crystal Layer

The production process of the photonic crystal layer will be described below. A metalorganic vapor phase epitaxy (MOVPE) method was used as the crystal growth method. In the following, a method of forming the photonic crystal layer 14P will be described taking, as an example, a case in which the photonic crystal layer 14P is a double lattice photonic crystal layer, but a single lattice photonic crystal layer and a multiple lattice photonic crystal layer can also be formed in the same manner.

(a) Formation of Holes

First, an n-type $Al_{0.04}Ga_{0.96}N$ layer having an Al composition of 4% was grown on the substrate 12 as the n-cladding layer 13. Subsequently, an n-type GaN layer was grown on the n-cladding layer 13. The growth layer is a preparation layer for forming the lower guide layer 14A and the photonic crystal layer 14P.

After forming the aforementioned preparation layer, the substrate was removed from the chamber of an MOVPE apparatus, and fine hole portions (holes) were formed on the surface of the growth layer. After a clean surface is obtained by washing, a silicon nitride film ($SiN_x$) was formed into a film using plasma CVD. A resist for electron beam lithography was applied thereon, and the resist was placed in an electron beam lithography apparatus to perform patterning of a two-dimensional periodic structure.

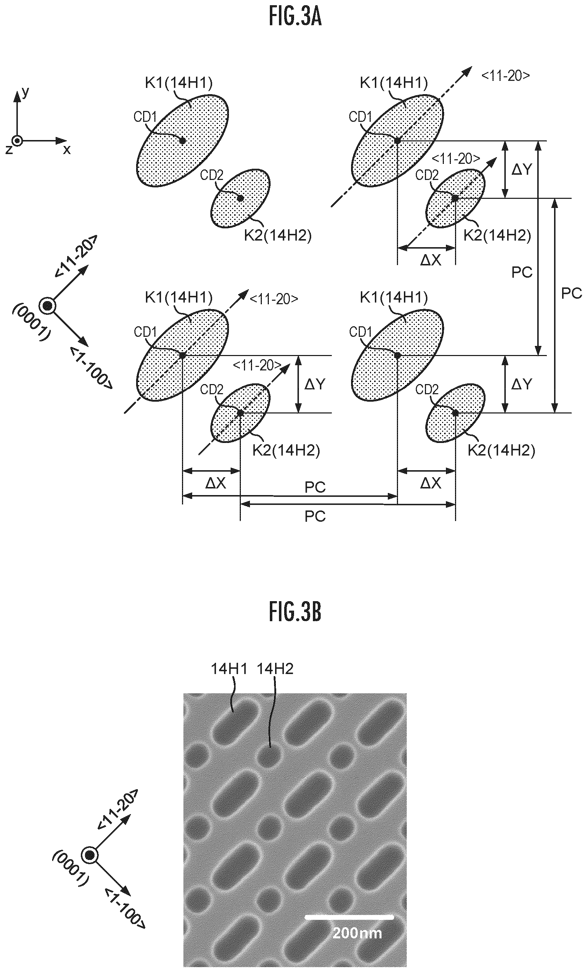

FIG. 3A is a plan view schematically illustrating a main opening K1 and a secondary opening K2 of a resist, and holes 14H1 and 14H2 after etching. As illustrated in FIG. 3A, patterning was performed by two-dimensionally arranging a pair of openings including the main opening K1 having an oval shape and the secondary opening K2 smaller than the main opening K1 in a square lattice shape in a plane of the resist with the period PC. For the sake of clarity in the drawings, the openings are hatched.

More specifically, centroids CD1 of the main openings K1 are arranged in a square lattice shape with the period PC in two directions (x direction and y direction) that are orthogonal to each other. Similarly, centroids CD2 of the secondary openings K2 are arranged in a square lattice shape with the period PC in the x direction and the y direction.

The major axis of the main opening K1 and the secondary opening K2 is parallel to a <11-20> direction of the crystal orientation, and the minor axis of the main opening K1 and the secondary opening K2 is parallel to a <1-100> direction.

Further, the centroid CD2 of the secondary opening K2 is separated from the centroid CD1 of the main opening K1 by $\Delta x$ and $\Delta y$. Here, $\Delta x = \Delta y$ was set. That is, the centroid CD2 of the secondary opening K2 is separated from the centroid CD1 of the main opening K1 in the <1-100> direction.

Further, the distances $\Delta x$ and $\Delta y$ between the centroids of the main opening K1 and the secondary opening K2 were set to $\Delta x = \Delta y = 0.4$ PC. After the patterned resist was developed, a $SiN_x$ film was selectively dry-etched using an inductive coupled plasma-reactive ion etching (ICP-RIE) apparatus. Accordingly, the main opening K1 and the secondary opening K2, which are arranged in a square lattice shape with the period PC, were formed to penetrate the $SiN_x$ film.

The period (air hole spacing) PC was set to PC = 177.5 nm in order to set the oscillation wavelength ($\lambda$) to 438 nm.

Subsequently, the resist was removed, and hole portions (holes) were formed in a GaN surface portion using the patterned $SiN_x$ film as a hard mask. A main hole 14H1 and a secondary hole 14H2, which are dug perpendicularly to a GaN surface and are oblong columnar air holes, were formed by dry-etching GaN in a depth direction using a chlorine-based gas and an argon gas in the ICP-RIE apparatus.

In addition, the holes dug in the GaN surface portion by the above etching are simply referred to as main holes and secondary holes to distinguish them from air holes in photonic crystal layer 14P. Furthermore, in a case where the main hole 14H1 and the secondary hole 14H2 are not particularly distinguished from each other, they may be collectively referred to as the hole 14H.

The shape of the hole 14H is not limited to the oblong columnar shape, and may be a columnar shape, a polygonal shape, or the like.

FIG. 3B is a view illustrating a scanning electron microscope (SEM) image of a surface after the holes 14H1 and 14H2 are formed.

The formed main hole 14H1 had a major axis of 138.9 nm and a minor axis of 63.2 nm, and the major axis/minor axis ratio was 2.20. In addition, the formed secondary hole 14H2 had a major axis of 66.3 nm and a minor axis of 59.1 nm, and the major axis/minor axis ratio was 1.12.

It was also found that the main holes 14H1 and the secondary holes 14H2 were formed with a period PC of 177.5 nm and arranged in a square lattice pattern. At this time, the distances $\Delta x$ and $\Delta y$ between the centroids of the main hole 14H1 and the secondary hole 14H2 were 81.6 nm ($\Delta x = \Delta y = 0.46$ PC). The major axes of the main hole 14H1 and the secondary hole 14H2 were parallel to the <11-20> axis (that is, the a-axis).

(b) Formation of Embedded Layer

After cleaning the substrate in which the hole 14H was formed, the substrate was again introduced into a reactor of the MOVPE apparatus, and ammonia ($NH_3$), trimethylgallium (TMG), and $NH_3$ were supplied to close the opening of the hole 14H, thereby forming the first embedded layer 14B1.

That is, the first embedded layer 14B1 was formed at a first temperature (920°C) at which the shape of the hole 14H was deformed by mass transport into a shape formed of thermally stable surfaces.

In this first temperature region, since N atoms adhere to the outermost surface of the growth substrate, an N-polar plane is selectively grown. Therefore, {1-101} facets are selectively grown on the surface. The holes 14H are closed and embedded when the opposing {1-101} facets collide with each other. Accordingly, the first embedded layer 14B1 is formed.

Subsequently, the main hole 14H1 and the secondary hole 14H2 were closed, and then the second embedded layer 14B2 having a thickness of 50 nm was grown. The growth of the second embedded layer 14B2 was performed by lowering a substrate temperature (growth temperature) to 820°C (second embedding temperature) and then supplying triethylene gallium (TEG), trimethylindium (TMI), and $NH_3$. The second embedding temperature was lower than a first embedding temperature.

In addition, the In composition of the second embedded layer 14B2 in the present example was 3% (that is, $Ga_{0.97}In_{0.03}N$ layer). The second embedded layer 14B2 also functions as a light distribution adjustment layer for adjusting the coupling efficiency (light field) between the light and the photonic crystal layer 14P.

By the above embedding process, the photonic crystal layer 14P having a double lattice structure was formed in which a pair of air holes 14K including a main air hole 14K1 and a secondary air hole 14K2 are disposed at each of the square lattice points. Here, the secondary air hole 14K2 has a smaller air hole diameter and depth (height) than the main air hole 14K1.

In addition, in a case where the main air hole 14K1 and the secondary air hole 14K2 are not particularly distinguished from each other, they may be collectively referred to as the air hole 14K.

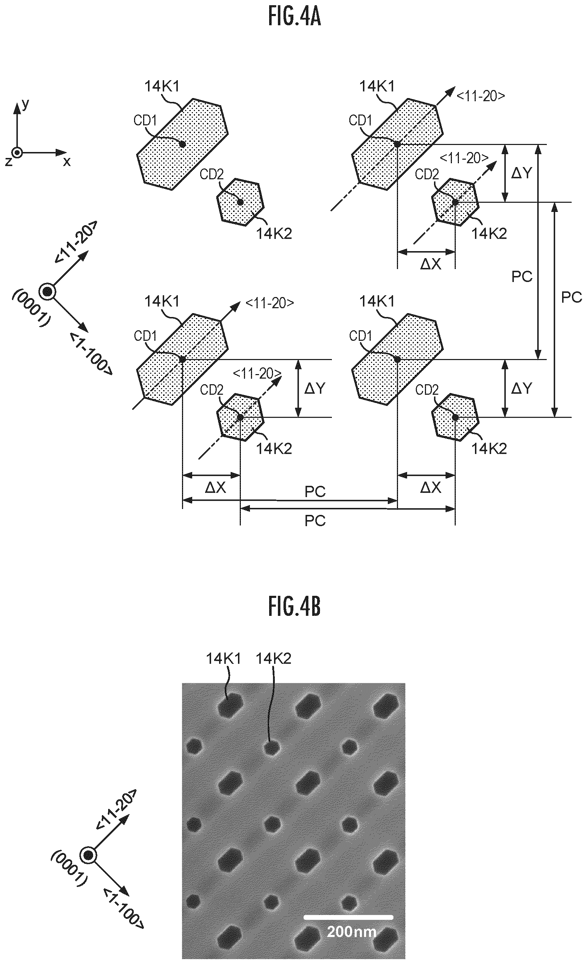

FIG. 4A is a view schematically illustrating a cross section of the formed photonic crystal layer 14P, perpendicular to a crystal layer. When the holes are embedded in group III nitride, the shapes of the holes 14H are deformed into shapes configured with thermally stable surfaces by mass transport, and air holes 14K are formed.

That is, in a +c-plane substrate, the shape of the inner side surface of the hole 14H changes to a (1-100) plane (that is, an m plane). That is, the shape changes from an oblong columnar shape to a long hexagonal columnar shaped air hole 14K whose side surfaces are configured with the m-plane.

FIG. 4B is a view illustrating an SEM image of a surface after the main air holes 14K1 and the secondary air holes 14K2 are formed.

The formed main air hole 14K1 had a long hexagonal column shape with a major axis of 72.5 nm and a minor axis of 43.5 nm, with a major axis/minor axis ratio of 1.67. The secondary air hole 14K2 had a major axis of 44.6 nm and a minor axis of 38.3 nm, with a major axis/minor axis ratio of 1.16, and had a long hexagonal column shape closer to a regular hexagonal prism than the main air hole 14K1.

Moreover, it was confirmed that the distances $\Delta x$ and $\Delta y$ between the centroids of the main air hole 14K1 and the secondary air hole 14K2 were 81.6 nm ($\Delta x = \Delta y = 0.46$ PC), and had not changed since before the embedding. It was also confirmed that the major axes of the main air hole 14K1 and the secondary air hole 14K2 were parallel to the <11-20> axis (that is, the a-axis).

Moreover, air hole filling rates (filling factors) FF1 and FF2 of the main air hole 14K1 and the secondary air hole 14K2 were calculated to be FF1 = 8.8% and FF2 = 4.2%. The air hole filling rate herein means a proportion of the area occupied by each air hole per unit area in a two-dimensional regular array. Specifically, when the areas of the main air holes 14K1 and the secondary air holes 14K2 in the photonic crystal layer 14P are S1 and S2, respectively, the air hole filling rates FF1 and FF2 of the main air holes 14K1 and the secondary air holes 14K2 are given by the following expressions.

$$FF1 = S1/PC^2, FF2 = S2/PC^2$$

Through the above processes, the formation of the n-side guide layer 14 including the photonic crystal layer 14P, which is an air-hole layer, was completed.

3. Element Characteristics and Theoretical Examination

(a) Element Characteristics

PCSEL elements 10 were produced with different layer thicknesses of the p-cladding layer 18 (first p-cladding layer), and the element characteristics were evaluated. The structures such as composition and layer thickness of each of the semiconductor layers other than the p-cladding layer 18 are the same.

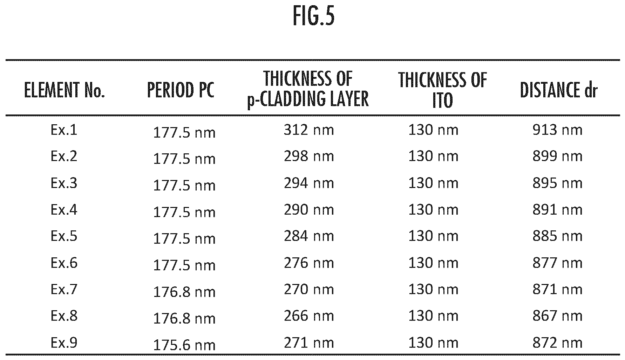

FIG. 5 is a table showing an air hole period PC, a layer thickness of the p-cladding layer 18, a layer thickness of the light-transmitting electrode 31 (ITO), and a separation distance dr from the wave source WS to the p-electrode 20B (that is, the reflecting surface SR) of the produced example elements Examples. 1 to 9 (hereinafter, Ex. 1 to Ex. 9).

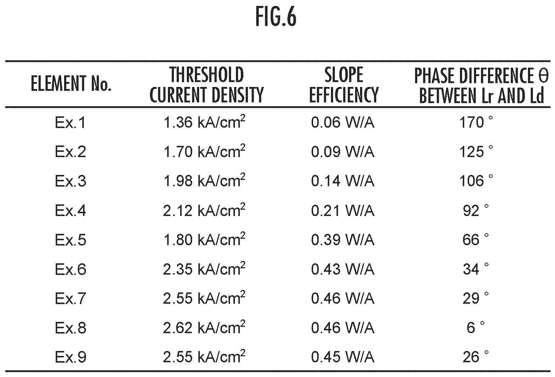

FIG. 6 is a table showing a threshold current density, a slope efficiency, and a phase difference $\theta$ between direct diffracted light Ld and reflected diffracted light Lr of the elements illustrated in FIG. 5.

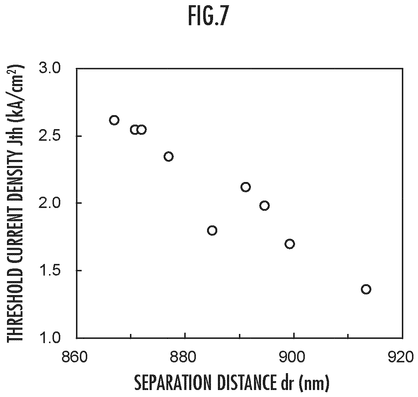

FIG. 7 is a graph plotting a threshold current density Jth (kA/cm$^2$) with respect to a separation distance dr (nm) for the above elements.

As illustrated in FIGS. 6 and 7, it was found that in the separation distances dr of the elements 1 to 9 of the present example, the threshold current density Jth tends to decrease monotonically with the separation distance dr.

For example, from Non Patent Literature 1, the coupled wave theory can be used to calculate the position (or diffraction surface) of the wave source WS, which is the diffraction position of the diffracted wave by the photonic crystal layer 14P, and the radiated wave that is diffracted and radiated in the vertical direction of the photonic crystal layer 14P. Therefore, the position of the wave source WS can be used to calculate the separation distance dr between the wave source WS and the reflecting surface SR.

(b) Resonator Loss in Vertical Direction

In a case where the resonator loss in the direction perpendicular to the photonic crystal layer 14P is denoted by $\alpha v$, the resonator loss in the horizontal direction is denoted by $\alpha p$, the absorption loss due to the material is denoted by $\alpha i$, the gain of the active layer is denoted by g, and the proportion of the electromagnetic field distribution present in the active layer is denoted by $\Gamma_{act}$, the gain condition for oscillation in the photonic-crystal surface-emitting laser is expressed by the following Expression (1).

In the following, the resonator loss $\alpha v$ in the vertical direction, the resonator loss $\alpha p$ in the horizontal direction, and the absorption loss $\alpha i$ due to the material will also be expressed as follows.

$$\alpha_\perp, \ \alpha_{//}, \ \alpha_i$$

$$\Gamma_{act}g = \alpha_\perp + \alpha_{//} + \alpha_i \qquad (1)$$

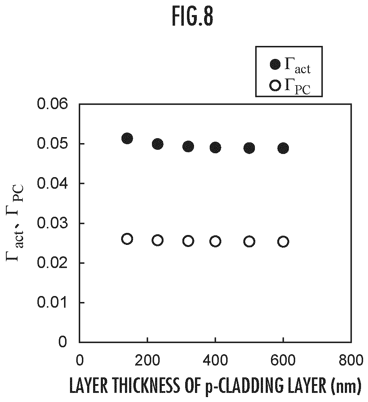

In the structures of the PCSEL elements 10 (Ex. 1 to Ex. 9) described above, when the proportions (light confinement rates) of the electromagnetic field distribution that are present in the active layer and the photonic crystal layer in the electromagnetic field distribution in the fundamental mode are denoted by $\Gamma_{act}$ and $\Gamma_{PC}$, respectively, $\Gamma_{act}$ and $\Gamma_{PC}$ with respect to the thickness of the p-cladding layer 18 (first p-cladding layer) are illustrated in FIG. 8.

In a case where the thickness of the p-cladding layer 18 is about 300 nm or more, $\Gamma_{act}$ and $\Gamma_{PC}$ do not depend on the thickness of the p-cladding layer 18. That is, in the elements Ex. 1 to Ex. 9, the left side of Expression (1) does not change.

Furthermore, the elements Ex. 1 to Ex. 9 use the photonic crystal layers 14P of the same structure, and if there is no change in $\Gamma_{PC}$, the same resonance effect of the photonic crystal layer can be obtained in each element. That is, the resonator loss $\alpha p$ in the horizontal direction has the same value for each element.

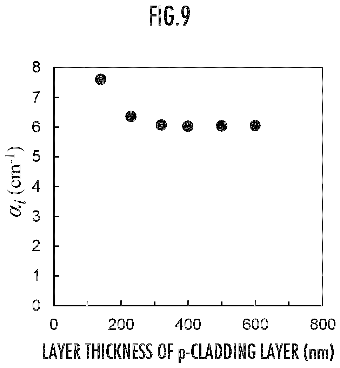

Moreover, the main material absorption at the resonant wavelength occurs in the Mg-doped layer, the InGaN layer in the contact layer, and the ITO layer. When absorption coefficients in each layer are set to 100, 50,000, and 2,600 $cm^{-1}$, respectively, and multiplied by the proportion of the electromagnetic field distribution present in each layer, and the sum thereof is defined as an absorption loss $\alpha i$, $\alpha i$ with respect to the thickness of the p-cladding layer 18 is illustrated in FIG. 9.

As illustrated in FIG. 9, in a case where the thickness of the p-cladding layer 18 is about 300 nm or more, $\alpha i$ does not depend on the thickness of the p-cladding layer 18. Therefore, it can be said that the change in the threshold current density Jth with respect to the separation distance dr (FIG. 7) is due to the change in the resonator loss $\alpha v$ in the vertical direction in Expression (1).

(c) Threshold Current Density

The resonant light propagating within the photonic crystal layer 14P is diffracted by the photonic crystal in a direction perpendicular to the photonic crystal layer 14P. At this time, the resonant light can be considered to be diffracted at the position of the wave source WS present within the photonic crystal layer 14P.

By using the method described in Non Patent Literature 1, the position of the wave source WS in the photonic crystal layer 14P in the example can be estimated. That is, it was estimated that the wave source WS was located about 7 nm closer to the active layer 15 side than the center of the photonic crystal layer 14P.

An electric field amplitude and an energy intensity of the light diffracted in the vertical direction by the wave source WS in the photonic crystal layer 14P, that is, the direct diffracted light Ld that is diffracted toward the back surface (emission surface) 12R (-z direction) of the substrate 12 and directly emitted, and the reflected diffracted light Lr that is diffracted in a +z direction and reflected by the reflecting surface SR and emitted, are respectively expressed by the following expressions.

$$E_0 e^{ikz} \quad , \quad \left| E_0 e^{ikz} \right|^2$$

Here, if diffraction occurs evenly in the +z direction and the -z direction, the electric field amplitudes of the direct diffracted light Ld and the reflected diffracted light Lr will be equal and can be expressed by the following expression.

$$\frac{1}{\sqrt{2}} E_0 e^{ikz}$$

The electric field amplitude when the wave is reflected by the reflecting surface SR and returns to the wave source WS is expressed by the following expression.

$$\frac{\sqrt{R}}{\sqrt{2}} E_0 e^{i(kz+\theta)}$$

Here, R is an energy reflectance of the reflecting surface SR, and $\theta$ is a phase difference between the direct diffracted light Ld and the reflected diffracted light Lr at the wave source WS.

Therefore, in a case where the direct diffracted light Ld and the reflected diffracted light Lr interfere with each other at the wave source WS, the electric field amplitude of the light that contributes to emission is expressed by the following Expression (2).

$$\frac{1}{\sqrt{2}} E_0 e^{ikz} + \frac{\sqrt{R}}{\sqrt{2}} E_0 e^{i(kz+\theta)} = \frac{1}{\sqrt{2}} E_0 (1 + \sqrt{R} e^{\theta}) e^{ikz} \qquad (2)$$

On the other hand, the electric field amplitude of the light component of the reflected diffracted light Lr that is absorbed by the reflecting surface SR is expressed by the following expression.

$$\frac{\sqrt{1-R}}{\sqrt{2}} E_0 e^{ikz}$$

Therefore, the light diffracted by the wave source WS in the photonic crystal layer 14P and lost from the resonator is expressed by the following Expression (3).

$$\left|\frac{1}{\sqrt{2}}(1 + \sqrt{R}e^{\theta})E_0 e^{ikz}\right|^2 + \left|\frac{\sqrt{1-R}}{\sqrt{2}} E_0 e^{ikz}\right|^2 = \left(1 + \sqrt{R}\cos\theta\right)\left|E_0 e^{ikz}\right|^2 \qquad (3)$$

That is, if the interference between the direct diffracted light Ld and the reflected diffracted light Lr affects the resonator loss, the loss αv in the vertical direction is multiplied by (1+R$^{1/2}$cosθ).
At this time, the gain condition of the oscillation is expressed by the following Expression (4).

$$\Gamma_{act}g = \left(1 + \sqrt{R}\cos\theta\right)\alpha_\perp + \alpha_{//} + \alpha_i \qquad (4)$$

In a case where the thickness of the active layer 15 is thin, such as a few nm, a threshold current and a threshold gain are roughly proportional to each other, and thus the threshold current density Jth can be expressed by the following Expression (5) using a proportionality constant A.

$$J_{th} = A\left(\left(1 + \sqrt{R}\cos\theta\right)\alpha_\perp + \alpha_{//} + \alpha_i\right) \qquad (5)$$

$$\alpha_\perp, \ \alpha_{//}, \ \alpha_i$$

In addition, if the above numerical expression is constant regardless of the current, then

$$B = \alpha_\perp + \alpha_{//} + \alpha_i$$

as such, the threshold current density Jth can be expressed by the following Expression (6).

$$J_{th} = A\left(\sqrt{R}\cos\theta + B\right) \qquad (6)$$

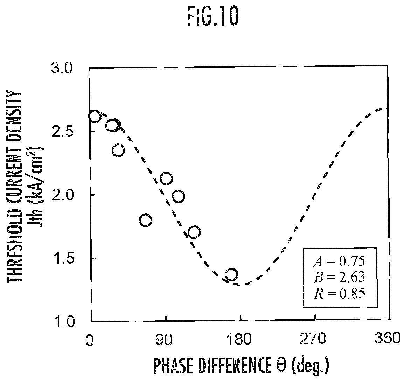

FIG. 10 is a diagram illustrating the threshold current density Jth with respect to the phase difference θ between the direct diffracted light Ld and the reflected diffracted light Lr, obtained based on the separation distance dr from the wave source WS to the reflecting surface SR, for the PCSEL elements 10 (Ex. 1 to Ex. 9).
The phase difference θ can be expressed by the following Expression (7), where k is the wave number of the emitted light and x is the optical path length.

$$kx = \left(\frac{\theta}{360}2\pi + \pi + 2m\pi\right), \quad \text{here,} \ k = \frac{2\pi}{\lambda}, \ x = 2n_{ave}dr \qquad (7)$$

In addition, in FIG. 10, the calculated value (broken line) of the threshold current density Jth obtained from Expression (6) when A = 0.75, B = 2.63, and R = 0.85 is shown, and the results obtained were in good agreement with this calculated value.
That is, by adjusting the separation distance dr from the wave source WS to the reflecting surface SR, the loss αv of the light propagating from the photonic crystal layer 14P can be reduced.
Therefore, loss due to diffraction of light propagating in the vertical direction from the photonic crystal layer 14P can be reduced, and the threshold current density can be lowered. That is, it is possible to provide a two-dimensional photonic-crystal surface-emitting laser that can be driven with a low current.

(d) Loss in Vertical Direction (Feature Specific to PCSEL)

A unique feature of photonic crystal light-emitting lasers is that they can utilize the interference of diffracted light emitted in a direction perpendicular to the photonic crystal layer. This point will be described below.

In general edge lasers or vertical cavity surface-emitting lasers (VCSELs), it is difficult to control a loss of the resonator by utilizing light emitted outside the resonator, that is, by diffraction from the resonator.

On the other hand, in a two-dimensional photonic-crystal surface-emitting laser, a resonance effect is obtained by utilizing the effect that the group velocity becomes zero at the Γ point of the two-dimensional photonic crystal. That is, the resonator of the two-dimensional photonic-crystal surface-emitting laser is a two-dimensional photonic crystal layer. Therefore, light diffracted by the photonic crystal to the outside of the resonator is necessarily diffracted in a vertical direction with respect to the photonic crystal layer.

Therefore, by disposing a reflecting surface parallel to the photonic crystal layer, the optical path length of the light diffracted by the resonator can be uniquely determined. That is, the loss of the resonator can be controlled by utilizing the diffracted light from the resonator, and the gain required for oscillation can be reduced. That is, low current driving is possible.

(e) Range of Separation Distance dr

As described above, it has been shown that the loss due to diffraction in the vertical direction in the photonic crystal layer 14P can be controlled by controlling the interference between the direct diffracted light Ld and the reflected diffracted light Lr through the separation distance dr from the wave source WS to the reflecting surface SR.

In order to reduce the threshold current density compared to the case where there is no reflection from the reflecting surface SR, the separation distance dr is only required to be determined such that the right side of Expression (4) is smaller than the right side of Expression (1).

That is, it is sufficient to satisfy the following Expression (8).

$$\left(1 + \sqrt{R}\cos\theta\right) < 1 \qquad (8)$$

From Expression (7), the separation distance dr can be expressed by the following Expression (9) when the phase difference is denoted by θ, the wavelength of the diffracted light is denoted by λ, the average refractive index of the crystal layer from the wave source WS (diffraction surface) to the reflecting surface SR is denoted by $n_{ave}$, and m is an integer equal to or greater than 0.

$$dr = \left(\frac{\theta}{360} + 0.5 + m\right)\frac{\lambda}{2n_{ave}} \qquad (9)$$

Therefore, from Expression (8), if the phase difference θ satisfies the following Expression (10), the loss due to diffraction in the vertical direction can be reduced compared to the case where there is no interference between the direct diffracted light Ld and the reflected diffracted light Lr.

$$\cos\theta < 0 \qquad (10)$$

That is, under this condition, the light intensity of the interference light between the direct diffracted light Ld and the reflected diffracted light Lr is smaller than the light intensity of the direct diffracted light Ld.

In other words, this means that emitted light is weakened by the interference between the direct diffracted light Ld and the reflected diffracted light Lr, and the radiation loss (loss in the vertical direction) αv is reduced.

In order to prevent interference (mutual weakening) from occurring inside the photonic crystal layer 14P, the photonic crystal layer 14P preferably has a thickness ($d_{PC}$) such that the optical path length of the photonic crystal layer 14P is less than one wavelength.

Therefore, a two-dimensional photonic-crystal surface-emitting laser that can be driven with a low current can be obtained.

(f) Layer Thickness of p-Cladding Layer

The interference between the direct diffracted light Ld and the reflected diffracted light Lr is determined by the separation distance dr between the wave source WS and the reflecting surface SR.

As described above, the PCSEL elements 10 (Ex. 1 to Ex. 9) have the same structure, such as composition and layer thickness, except that the layer thickness of the p-cladding layer 18 (first p-cladding layer) is different. Therefore, the conditions of the layer thickness of the p-cladding layer 18 will be examined below.

Specifically, the layer thickness of the p-cladding layer 18 is only required to be such that the separation distance dr from the wave source WS to the reflecting surface SR, as shown in Expression (9), satisfies Expression (10).

However, with reference to FIG. 9, it can be seen that when the layer thickness of the p-cladding layer 18 becomes approximately 150 nm or less, the loss $\alpha i$ due to material absorption increases. This is because the p-cladding layer 18 is thinner, which weakens the confinement of the electromagnetic field distribution in the fundamental mode in the core layer (active layer and guide layer).

That is, the fundamental mode is distributed more in the doping layer, the contact layer (InGaN), and the light-transmitting electrode layer (ITO), resulting in increased light absorption. That is, the layer thickness of the p-cladding layer 18 is preferably 150 nm or more.

(g) Reflectance of Reflecting Surface SR

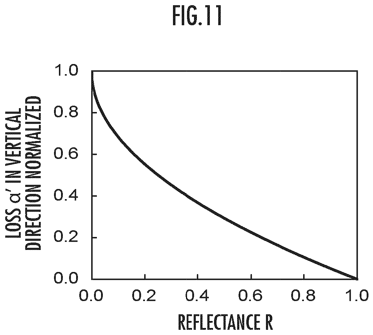

From Expression (4), the effective loss in the vertical direction in the photonic crystal layer 14P is $(1 + R^{1/2}\cos\theta)\alpha v$, and the magnitude of this loss varies depending on the reflectance R of the reflecting surface SR. FIG. 11 illustrates the change in the loss $\alpha$' in the vertical direction normalized at the value of R = 0 with respect to the reflectance R when the phase difference $\theta$ between the direct diffracted light Ld and the reflected diffracted light Lr is 180°. It can be seen from FIG. 11 that the loss $\alpha$' changes more rapidly as the reflectance R decreases, and can be significantly reduced by the reflectance R.

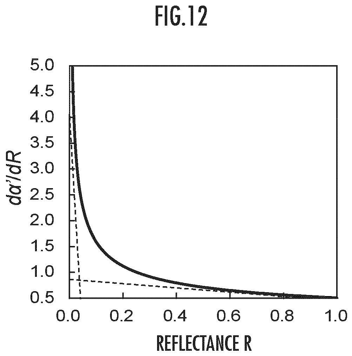

FIG. 12 illustrates the differential of the loss $\alpha$' with respect to the reflectance R (that is, $d\alpha$'/dR). When the reflectance R changes from 0 to about 0.05, $d\alpha$'/dR decreases significantly. Therefore, if the reflectance R is greater than 0.05, the effective loss in the vertical direction in the photonic crystal layer 14P can be significantly reduced. That is, the reflectance R is preferably greater than 0.05.

Also, from FIG. 12, when the reflectance R becomes greater than 0.6, $d\alpha$'/dR does not change with respect to R. Thus, by making the reflectance R greater than 0.6, the effective loss in the vertical direction in the photonic crystal layer can be kept small. That is, the reflectance R is more preferably greater than 0.6.

(h) Photonic Crystal Layer Having Double Lattice Structure

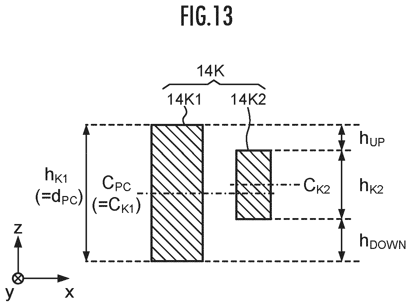

FIG. 13 is a cross-sectional view schematically illustrating a cross section of the arrangement of the main air hole 14K1 and the secondary air hole 14K2 in the depth direction of the double lattice structure. Here, the main air hole 14K1 and the secondary air hole 14K2 have different air hole heights. That is, the height of the main air hole 14K1 is $h_{K1}$, which is equal to the thickness of the photonic crystal layer 14P ($h_{K1} = d_{PC}$). Also, the height of the secondary air hole 14K2 is $h_{K2}$.

More specifically, the lower end of the main air hole 14K1 is located deeper than the lower end of the secondary air hole 14K2, that is, in the -z direction. The difference between the lower ends of the main air hole 14K1 and the secondary air hole 14K2 is $h_{DOWN}$. In addition, the upper end of the secondary air hole 14K2 is deeper than the upper end of the main air hole 14K1, and the difference therebetween is $h_{UP}$.

Here, the difference $h_{UP}$ between the upper ends is smaller than the difference $h_{DOWN}$ between the lower ends, and the center $C_{PC}$ (= $C_{K2}$) of the secondary air hole 14K2 in the depth direction (-z direction) is located closer to the side of the active layer 15 than the center $C_{K1}$ of the main air hole 14K1.

In a nitride-based PCSEL element, in a case where holes of different sizes are formed simultaneously by a method such as dry etching and the holes are embedded to form the main air holes 14K1 and the secondary air holes 14K2, the side surfaces of the formed main air holes 14K1 and secondary air holes 14K2 each have a hexagonal columnar structure with m-plane sides, and therefore the size relationship between the main air holes 14K1 and the secondary air holes 14K2 at any z-direction position in the photonic crystal layer 14P is the same as the size relationship between the holes before embedding.

In the photonic crystal layer 14P of the nitride-based PCSEL element, the lower ends of the main air holes 14K1 having a large air hole filling rate FF are located closer to the side of the lower end of the photonic crystal layer 14P than the secondary air holes 14K2, that is, the main air holes 14K1 are deeper than the secondary air holes 14K2. Moreover, the upper end of the secondary air hole 14K2 is formed deeper than the upper end of the main air hole 14K1 by the embedding growth.

Furthermore, in a case where the active layer 15 is formed after the photonic crystal layer 14P is formed, that is, in a case where the photonic crystal layer 14P is provided on the -z direction side of the active layer 15, the relationship FF1 > FF2 is always satisfied. That is, in a nitride-based PCSEL element, even in the case of a double lattice structure, the wave source (diffraction surface) WS is always located at a position, for example, about 0 to 10 nm away from the center $C_{PC}$ (that is, the center of the main air hole 14K1) in the z direction of the photonic crystal layer 14P toward the active layer 15.

Therefore, in the depth direction (-z direction), there are regions ($h_{UP}$ and $h_{DOWN}$ regions) where only the main air holes 14K1 are present, and regions ($h_{K2}$ regions) where both the main air holes 14K1 and the secondary air holes 14K2 are present, but the propagating light components diffracted in the vertical direction are larger in the regions where both the main air holes 14K1 and the secondary air holes 14K2 are present. Accordingly the wave source (diffraction surface) WS is also located at a position shifted in the +z direction (towards the active layer 15) from the center $C_{PC}$ of the photonic crystal layer 14P.

In the above, the air hole has been described in which the air hole has a hexagonal columnar shape and the cross-sectional area does not change in the depth direction. When either the main air hole 14K1 or the secondary air hole 14K2 has a shape in which the cross-sectional area changes in the depth direction, it is preferable that the centroid of the secondary air hole 14K2 is located closer to the side of the active layer 15 than the centroid of the main air hole 14K1.

As described above in detail, according to the present invention, it is possible to provide a photonic-crystal surface-emitting laser capable of reducing an emission loss, reducing an oscillation threshold current, and reducing a drive current.

The numerical values in the above-described embodiments are merely examples, and can be appropriately modified and applied. Although a PCSEL element having a double lattice structure has been exemplified, the present invention can be applied to a PCSEL element having a single lattice structure, and generally to a PCSEL element having a multiple lattice structure.

In addition, the present invention has been exemplified with respect to a photonic crystal layer in which the air hole has a hexagonal columnar shape, but also can be applied to a case where the air hole of the photonic crystal layer has a columnar shape, a rectangular shape, a polygonal shape, or an irregular columnar shape such as a teardrop shape.

Description of Reference Numerals

10: PCSEL element
12: substrate
13: first cladding layer
14: first guide layer
14A: lower guide layer
14B: embedded layer
14K: air hole/pair of air holes
14K1/14K2: main/secondary air hole
14P: photonic crystal layer (air-hole layer)
15: active layer
16: second guide layer
17: electron blocking layer
18: second cladding layer
19: contact layer
20A: first electrode
20B: second electrode
20L: light emission region
27: anti-reflection film
31: light-transmitting conductive layer
CD1, CD2: centroid
dr: separation distance
Ld: direct diffracted light
Lr: reflected diffracted light
SR: reflecting surface

**Claims**

1. A surface-emitting laser element comprising:

a light-transmitting substrate;
a first semiconductor layer that is provided on the substrate;
an active layer that is provided on the first semiconductor layer;
a second semiconductor layer that is provided on the active layer;

a photonic crystal layer that is included in the first semiconductor layer and includes air holes disposed with a two-dimensional periodicity in a plane parallel to the active layer; and
a light reflection layer that is provided on the second semiconductor layer and has a reflecting surface,
wherein a light emission surface is provided on a back surface of the substrate,
the photonic crystal layer has a diffraction surface that is a wave source when light standing in the photonic crystal layer is diffracted in a direction orthogonal to the photonic crystal layer, and
a separation distance between the diffraction surface and the reflecting surface is provided such that a light intensity of interference light generated by interference between first diffracted light diffracted from the diffraction surface to a side of the light emission surface and second diffracted light diffracted from the diffraction surface to a side of the light reflection layer and reflected on the reflecting surface is smaller than a light intensity of the first diffracted light.

2. The surface-emitting laser element according to Claim 1,
wherein the diffraction surface is located closer to a side of the active layer than a center of the photonic crystal layer in a depth direction.

3. The surface-emitting laser element according to Claim 1,
wherein the first semiconductor layer, the active layer, and the second semiconductor layer are group III nitride-based semiconductor layers, and the first semiconductor layer and the second semiconductor layer are n-type and p-type semiconductor layers, respectively.

4. The surface-emitting laser element according to Claim 1,

wherein when a phase difference between the first diffracted light and the second diffracted light is denoted by $\theta$, a wavelength of the first diffracted light is denoted by $\lambda$, an average refractive index of a crystal layer from the diffraction surface to the reflecting surface is denoted by $n_{ave}$, the separation distance is denoted by dr, and m is an integer equal to or greater than 0, the separation distance dr is expressed by the following expression,

$$\mathrm{dr} = \left(\frac{\theta}{360} + 0.5 + m\right)\frac{\lambda}{2n_{ave}} \quad (9)$$

,

and
the phase difference $\theta$ satisfies the following expression

$$\cos\theta < 0 \quad (10)$$

5. The surface-emitting laser element according to Claim 1,
wherein the second semiconductor layer is a p-type semiconductor layer, and a light-transmitting conductive layer is provided between the reflecting surface and the second semiconductor layer.

6. The surface-emitting laser element according to Claim 1,
wherein the second semiconductor layer has a guide layer and a cladding layer having a refractive index smaller than a refractive index of the guide layer, and the cladding layer has a thickness of 150 nm or more.

7. The surface-emitting laser element according to Claim 1,
wherein a reflectance of the reflecting surface with respect to the second diffracted light is 0.05 or more.

8. The surface-emitting laser element according to Claim 1,
wherein a reflectance of the reflecting surface with respect to the second diffracted light is 0.6 or more.

9. The surface-emitting laser element according to Claim 1,
wherein the reflecting surface is parallel to the photonic crystal layer.

10. The surface-emitting laser element according to Claim 1,
wherein the photonic crystal layer has a thickness such that an optical path length of the photonic crystal layer is less than one wavelength.

11. The surface-emitting laser element according to any one of Claims 1 to 10,
    wherein the photonic crystal layer has a double lattice structure in which main air holes and secondary air holes having a smaller air hole diameter and a smaller height than the main air hole are disposed at lattice points, and a centroid position of the secondary air hole in a depth direction is closer to a side of the active layer than a centroid position of the main air hole.

## FIG.1A

## FIG.1B

FIG.2A

21

20B

FIG.2B

14P

14K1
14K2 } 14K

14R

FIG.2C

20A

20L

20B
(RA)

14R

20C

# FIG.3A

# FIG.3B

## FIG.4A

## FIG.4B

# FIG.5

| ELEMENT No. | PERIOD PC | THICKNESS OF p-CLADDING LAYER | THICKNESS OF ITO | DISTANCE dr |
|---|---|---|---|---|
| Ex.1 | 177.5 nm | 312 nm | 130 nm | 913 nm |
| Ex.2 | 177.5 nm | 298 nm | 130 nm | 899 nm |
| Ex.3 | 177.5 nm | 294 nm | 130 nm | 895 nm |
| Ex.4 | 177.5 nm | 290 nm | 130 nm | 891 nm |
| Ex.5 | 177.5 nm | 284 nm | 130 nm | 885 nm |
| Ex.6 | 177.5 nm | 276 nm | 130 nm | 877 nm |
| Ex.7 | 176.8 nm | 270 nm | 130 nm | 871 nm |
| Ex.8 | 176.8 nm | 266 nm | 130 nm | 867 nm |
| Ex.9 | 175.6 nm | 271 nm | 130 nm | 872 nm |

## FIG.6

| ELEMENT No. | THRESHOLD CURRENT DENSITY | SLOPE EFFICIENCY | PHASE DIFFERENCE θ BETWEEN Lr AND Ld |
|---|---|---|---|
| Ex.1 | 1.36 kA/cm$^2$ | 0.06 W/A | 170 ° |
| Ex.2 | 1.70 kA/cm$^2$ | 0.09 W/A | 125 ° |
| Ex.3 | 1.98 kA/cm$^2$ | 0.14 W/A | 106 ° |
| Ex.4 | 2.12 kA/cm$^2$ | 0.21 W/A | 92 ° |
| Ex.5 | 1.80 kA/cm$^2$ | 0.39 W/A | 66 ° |
| Ex.6 | 2.35 kA/cm$^2$ | 0.43 W/A | 34 ° |
| Ex.7 | 2.55 kA/cm$^2$ | 0.46 W/A | 29 ° |
| Ex.8 | 2.62 kA/cm$^2$ | 0.46 W/A | 6 ° |
| Ex.9 | 2.55 kA/cm$^2$ | 0.45 W/A | 26 ° |

FIG.7

# FIG.8

FIG.9

LAYER THICKNESS OF p-CLADDING LAYER (nm)

FIG.10

## FIG.11

# FIG.12

# FIG.13

## INTERNATIONAL SEARCH REPORT

| International application No. |
| --- |
| **PCT/JP2023/020608** |

**A. CLASSIFICATION OF SUBJECT MATTER**

*H01S 5/11*(2021.01)i; *H01S 5/183*(2006.01)i
FI: H01S5/11; H01S5/183

According to International Patent Classification (IPC) or to both national classification and IPC

**B. FIELDS SEARCHED**

Minimum documentation searched (classification system followed by classification symbols)

H01S5/00-5/50

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y | WO 2021/186965 A1 (KYOTO UNIVERSITY) 23 September 2021 (2021-09-23) paragraphs [0014]-[0070], fig. 1-8 | 1-11 |
| Y | JP 2018-41832 A (HAMAMATSU PHOTONICS KK) 15 March 2018 (2018-03-15) paragraphs [0019]-[0034], [0066]-[0076], [0092]-[0096], fig. 1-2, 20-22, 30-32 | 1-11 |
| Y | JP 2019-201065 A (HAMAMATSU PHOTONICS KK) 21 November 2019 (2019-11-21) paragraphs [0024]-[0030], [0049]-[0051], fig. 1-3, 9 | 5 |
| A | JP 2020-512700 A (KONINKLIJKE PHILIPS N.V.) 23 April 2020 (2020-04-23) entire text, all drawings | 1-11 |
| A | JP 2012-109410 A (CANON INC) 07 June 2012 (2012-06-07) entire text, all drawings | 1-11 |
| A | US 10340659 B1 (CONARY ENTERPRISE CO., LTD.) 02 July 2019 (2019-07-02) entire text, all drawings | 1-11 |

☐ Further documents are listed in the continuation of Box C.    ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **29 June 2023** | **11 July 2023** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2023/020608**

| Patent document cited in search report | | | Publication date (day/month/year) | Patent family member(s) | | Publication date (day/month/year) |
|---|---|---|---|---|---|---|
| WO | 2021/186965 | A1 | 23 September 2021 | EP 4105967 A1 paragraphs [0014]-[0090], fig. 1-8<br>CN 115298916 A | | |
| JP | 2018-41832 | A | 15 March 2018 | US 2019/0252856 A1 paragraphs [0065]-[0080], [0127]-[0138], [0156]-[0162], fig. 1-2, 20-22, 30-32<br>WO 2018/047717 A1<br>CN 109690890 A | | |
| JP | 2019-201065 | A | 21 November 2019 | US 2021/0273411 A1 paragraphs [0074]-[0080], [0100]-[0102], fig. 1-3, 9<br>WO 2019/221133 A1<br>CN 112119548 A | | |
| JP | 2020-512700 | A | 23 April 2020 | US 2020/0028329 A1 entire text, all drawings<br>WO 2018/178328 A1<br>EP 3382828 A1<br>CN 110537304 A<br>KR 10-2019-0125468 A | | |
| JP | 2012-109410 | A | 07 June 2012 | (Family: none) | | |
| US | 10340659 | B1 | 02 July 2019 | (Family: none) | | |

Form PCT/ISA/210 (patent family annex) (January 2015)

30

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008227095 A
- JP 2010232488 A
- JP 2014067945 A

**Non-patent literature cited in the description**

- **Y. LIANG et al.** *Phys. Rev. B*, 2011, vol. 84, 195119